Europäisches Patentamt

European Patent Office

Office européen des brevets

(11) Publication number: **0 042 175**
**B1**

# EUROPEAN PATENT SPECIFICATION

(45) Date of publication of patent specification: 09.09.87

(21) Application number: 81104653.1

(22) Date of filing: 16.06.81

(51) Int. Cl.⁴: **H 01 L 21/268**, H 01 L 29/78, H 01 L 27/12

(54) Method of fabricating a semiconductor device having a silicon-on-sapphire structure.

(30) Priority: 18.06.80 JP 81420/80

(43) Date of publication of application:
23.12.81 Bulletin 81/51

(45) Publication of the grant of the patent:
09.09.87 Bulletin 87/37

(84) Designated Contracting States:
DE FR

(56) References cited:
WO-A-80/00509
US-A-3 862 859
US-A-4 177 084

SOLID STATE TECHNOLOGY, Vol. 18, No. 8,
august 1975 Port Washington R.S. RONEN et
al. "Recent SOS Technology, Advances and
Applications"

(73) Proprietor: Hitachi, Ltd.
5-1, Marunouchi 1-chome
Chiyoda-ku Tokyo 100 (JP)

(72) Inventor: Kobayashi, Yutaka
531, Ishinazaka AP, 161, Ishinazaka-cho
Hitachi-shi Ibaraki (JP)
Inventor: Suzuki, Takaya
622-5, Ichige
Katsuta-shi Ibaraki (JP)

(74) Representative: Strehl, Peter, Dipl.-Ing. et al
Strehl, Schübel-Hopf, Schulz Patentanwälte
Widenmayerstrasse 17 Postfach 22 03 45
D-8000 München 22 (DE)

(56) References cited:
JOURNAL OF THE ELECTROCHEMICAL
SOCIETY, Vol. 121, No. 10, 1974 Princeton G.W
CULLEN et al. "A Comparison of the
Semiconducting Properties of Thin Films of
Silicon on Sapphire and Spinel"

IEEE TRANSACTIONS ON ELECTRON
DEVICES, Vol. ED-27, No. 3, March 1980 New
York G. YARON et al. "LASOS-Laser Annealed
Silicon on Sapphire"

**Description**

Usually, as a semiconductor substrate for forming a semiconductor integrated circuit device (IC), there has been proposed a structure in which a semiconductor single crystalline layer of Si or the like is grown on a high insulating single crystalline substrate of sapphire, spinel or the like. With such an SOS structure, the semiconductor single crystalline layer in which semiconductor elements are to be formed can be made quite thin without spoiling the mechanical strength, while at the same time a high insulation is achieved between the layer and the substrate, so that an IC can be realized having a high operating speed, a high integration and a low power dissipation.

Fundamentally, the SOS structure can be fabricated by a method similar to the epitaxial growth of a semi-conductor having hitherto been known well. With the conventional growth process, however, a satisfactory crystalline quality is difficult to be obtained for the reasons that an insulator which is widely different from a semiconductor in points of the lattice constant and the coefficient of thermal expansion is employed for the substrate and that the required thickness of the semiconductor single crystalline layer is extremely small, that is at most about 1 μm. Especially in case where a high-speed semiconductor device such as a logic element shall be fabricated by using the SOS structure, the mobility of carriers within the semiconductor single crystalline layer has to be relatively high. In case of prior art SOS structures, however, it has been difficult to make the mobility of carriers at least as high as in bulk semiconductor elements. Therefore, up to now the usage of SOS structures for high-speed ICs has been rather limited.

The mobility of carriers within semiconductor elements is lowered by all factors which can scatter the carriers. Such factors are, for example, the lattice of the semiconductor crystal, the impurity atoms with which the semiconductor is doped, stacking faults, dislocations and mechanical strains. Among them, the stacking faults, dislocations and mechanical strains are included in large quantities in the SOS structure and have rendered it difficult to raise the mobility.

More specifically, the substrate and the semiconductor to be grown thereon differ in the lattice constant, and both define the so-called heterojunction, so that twins, dislocations or stacking faults appear in large numbers at the interface of the two layers. The number of such disorders decreases gradually with the growth of the semiconductor. Since, however, the semiconductor layer is very thin—for example, 0.5—1 μm in case of an IC of the SOS structure—it cannot be avoided that regions are used as active parts of a semiconductor element in which the disorders have not decreased sufficiently. It has therefore been impossible to obtain a sufficiently high mobility. Due to the same cause, it has been impossible to make the leakage current of the semiconductor element low enough.

It has been reported by G. Yaron et al. that by irradiating a Si layer with a laser beam the crystalline quality of the top silicon surface of an SOS structure can be improved (see IEEE Trans. Electron Devices, vol. ED-27, pages 573 to 578, March, 1980). Thereby the authors aim at the crystalline quality of the top silicon surface and the reformation of silicon islands. As a laser beam they adopt therefore one of a wavelength (the wavelength λ of the eximer laser is 249 nm) and an energy density at which the absorption takes place substantially in the top silicon surface only.

The irradiation of a silicon layer with a laser beam has also been disclosed in US—A—3 585 088. In this case, an amorphous film of silicon deposited on a substrate is irradiated with a ruby laser beam thereby turning the same into a single crystalline silicon structure.

U.S. Patent Specification US—A—4 177 084 describes another method for producing a silicon layer on a sapphire substrate, in which the silicon layer is subjected to ion implantation to form an amorphous region in the silicon near the silicon-sapphire interface and the structure is subsequently annealed in two steps at temperatures of 600°C and 900°C, respectively. It is thus again attempted to convert a layer, which is previously monocrystalline only at its surface and amorphous underneath, into one which is monocrystalline from the upper surface down to the substrate.

It is an object of the present invention to improve the crystalline quality of the silicon layer of a silicon-on-sapphire structure, except a bottom portion of the silicon layer adjoining the substrate, to enhance the carrier mobility in the silicon layer, thereby enhancing the operating speed of a semiconductor device to be fabricated with such silicon-on-sapphire structure.

This object is met by the method set forth in Claim 1. The invention utilizes the fact that the carrier mobility in the silicon layer is increased by a tensile stress acting on the main or top surface of the re-crystallized layer. This tensile stress is retained if the heat treatment following the re-crystallization is performed at a temperature below 600°C.

Embodiments of the invention will now be described with reference to the accompanying drawings, in which:

Figure 1 is a view schematically showing the arrangement of a laser beam irradiation method and apparatus for use in an embodiment of this invention.

Figure 2 is a sectional view of an SOS, N-channel MOS transistor which is an embodiment of this invention.

Figure 3 is a view showing a section of SOS complementary MOS transistors and simultaneously exemplifying interconnections for constructing an inverter circuit.

Figure 4 is a graph showing the variation of the electron Hall mobility versus the annealing temperature after irradiation with a laser beam of an SOS structure whose top silicon main surface has the (100) orientation.

Figures 5A to 5D are sectional views each showing an essential step in an example of a preferred method of production in the case of making an N-channel MOS transistor in accordance with this invention.

Figures 6A to 6D are sectional views each showing an essential step in an example of another preferred method of production in the case of making an N-channel MOS transistor in accordance with this invention.

Description of the preferred embodiments

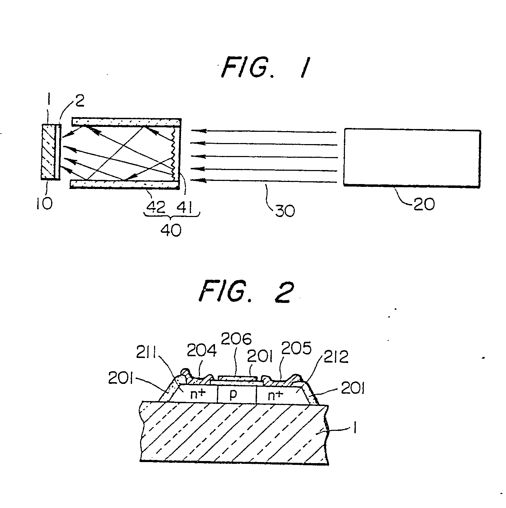

First of all, a method for making an SOS structure according to this invention will be exemplified with reference to Figure 1. A single crystalline sapphire substrate 1 having a diameter of approximately 50 mm, a thickness of approximately 0.3 mm and an orientation of $(1\bar{1}02)$ was prepared. A Si layer 2 with an orientation of (100) was epitaxially grown on the sapphire substrate by pyrolyzing silane ($SiH_4$) in a hydrogen atmosphere at 1,020°C. Phosphine was used as a dopant source to achieve a donor level of about $3\times10^{16}$ cm$^{-3}$. The electron Hall mobility in the Si layer 2 of this SOS structure was about 240 cm$^2$/V · s on the average.

In the formation of the SOS structure by the vapor growth as stated above, in case where the single crystalline sapphire substrate used has the facial orientation of $(1\bar{1}02)$ by way of example, the crystal faces of Si grown first are the two sorts of (100) and (110). When viewed microscopically, the Si does not become single crystalline but becomes a polycrystalline region in which two sorts of crystal grains of the different crystal faces aggregate. In the present invention, this region shall be termed the "interface layer". Such interface layer is formed up to a thickness of approximately 0.05 µm from the sapphire substrate by the conventional vapor growth, and contains in large quantities stacking faults, Al atoms and O atoms introduced from the sapphire substrate by the auto-doping, Si atoms not contributing to the formation of the crystal, and so forth.

The Si layer over the interface layer becomes a single crystalline layer whose crystal face is (100). In the grown state left intact, however, it still includes large numbers of stacking faults and dislocations, so that the mobility of carriers remains at the low value as described above.

Subsequently, the SOS structure was irradiated with a laser beam as shown in Figure 1. In the figure, numeral 10 designates the SOS structure consisting of the sapphire substrate 1 and the n-type single crystalline Si layer 2. Numeral 20 indicates a laser source, numeral 30 the laser beam emitted from the laser source 20, and numeral 40 a device for making the laser beam 30 uniform. The device 40 consists of a scatterer 41 and a reflector 42. The laser source 20 used in this example was a Q-switched ruby laser, the wavelength λ of which was 694.3 nm and the pulse width of one irradiation of which was 25 nsec. As the scatterer 41, a plate of ground glass is usable. Usable as the reflector 42 is a quartz cylinder whose inner surface is coated with a reflective material. The energy of the laser was made the three magnitudes of 1.0 J/cm$^2$, 1.5 J/cm$^2$ and 2.5 J/cm$^2$, and the Hall mobility of the Si layer 2 after the irradiation was measured as to the respective cases. The mobility is in a substantially proportional relationship with the operating speed of an element.

As a result, in case where the energy was made 1.0 J/cm$^2$, the Hall mobility after the irradiation did not exhibit a substantial change from that before the irradiation. Although the irradiation was conducted repeatedly in a range of two times to five times, the Hall mobility did not substantially change from the value of the Si layer without the irradiation yet. Next, in case where the energy was made 1.5 J/cm$^2$, the Hall mobility after the first irradiation was 270 cm$^2$/V · s on the average and merely increased to some extent in comparison with the value before the irradiation. However, when the re-growing step was repeated by the second, third and fourth irradiations, the Hall mobility exhibited large values in all the operations in such manner that the value after the second irradiation was approximately 540 cm$^2$/V · s and increased above double in comparison with the value of Si layer without the irradiation, that the value after the third irradiation was approximately 560 cm$^2$/V · s, and that the value after the fourth irradiation was approximately 580 cm$^2$/V · s. Next, in case where the energy was made 2.5 J/cm$^2$, the Hall mobility became as extremely low as approximately 10 cm$^2$/V · s. In addition, the n-type Si layer was inverted into the p-type.

The above experimental results are tabulated below so as to facilitate understanding.

TABLE

| Energy density (J/cm$^2$) | Hall mobility (cm$^2$/V · s) | | | | | | Notes |
|---|---|---|---|---|---|---|---|
| | Times of irradiation | | | | | | |
| | 0 | 1 | 2 | 3 | 4 | 5 | |
| 1.0 | 240 | 170 | — | 280 | — | 195 | — |
| 1.5 | 240 | 270 | 540 | 560 | 580 | 380 | — |
| 2.5 | 240 | 10 | — | — | — | — | n-Si changed to p-Si. |

The Si layers of the SOS structures subjected to the two or more times of irradiation and re-growth steps at the energy density of 1.5 J/cm$^2$ had disorders etched selectively, and the resultant surfaces were observed with a scanning electron microscope. As a result, the stacking faults were hardly observed, and the number of etch pits corresponding to the dislocations decreased to 1/3—1/5 in comparison with the number in the Si layer not irradiated.

The cause by which the Hall mobility was lowered in the extreme at the energy density of 2.5 J/cm$^2$ is conjectured to be that since the energy was excessive for the Si layer used in the example, the entire Si layer including the interface layer was molten by the irradiation, with the result that the crystal to serve as the seed during the re-growth turned into twins and that a polycrystalline or amorphous Si layer was re-grown. The cause for the p-type inversion is conjectured to be that since the interface between the sapphire substrate and the Si layer was excessively heated, the Al atoms in the sapphire substrate were introduced into the molten Si and spread into the Si layer along with the re-growth of Si.

The cause by which no effect was demonstrated in the case of the energy of 1.0 J/cm$^2$ is not definite, but is conjectured to be that the energy of 1.0 J/cm$^2$ will be insufficient for melting or re-growing the Si layer. Even with the equal energy of 1.0 J/cm$^2$, when the wavelength of the laser is short, the absorption coefficient in Si increases, and a very thin surface part of the Si layer is molten. For example, when an excimer laser whose wavelength $\lambda$ is 248 nm is used, an extent of approximately 10$^{-7}$ cm or 10$^{-3}$ μm from the top surface is molten because the absorption coefficient of Si at this wavelength is approximately 10$^7$ cm$^{-1}$. Since, however, the thickness of the Si layer of the SOS structure for use in an IC is ordinarily 0.4—0.5 μm or greater, the effect of this invention cannot be expected with the low-energy laser of such short wavelength. In case where a short-wavelength laser is operated at high energy, unfavorably the surface of the Si layer is overheated near to the boiling point of Si to worsen the crystalline quality in the surface because most of the energy is absorbed by the surface part. In, for example, a MOS type transistor, such worsening of the crystalline quality in the Si surface appears as the dispersion of the threshold voltage $V_{th}$. In this manner, the electromagnetic wave for use in the present invention needs to melt or re-grow substantially the whole semiconductor layer uniformly, except the bottom portion thereof.

In the foregoing case where the energy was made 1.5 J/cm$^2$ with the Q-switched ruby laser, the Hall mobility after repeating the irradiation five or more times was approximately 380 cm$^2$/V · s lower than the value after repeating the irradiation two to four times. Accordingly, the repeated irradiation of 2—4 times is desirable under the irradiation conditions stated above.

Now, an example of a MOS transistor fabricated in accordance with the above method will be described with reference to Figure 2. As the SOS structure, one prepared by the foregoing process was used. In the melting and re-growing process by the irradiation with the laser beam, the energy density was 1.5 J/cm$^2$ and the number of times of the irradiation was three. Using known photolithography, selective diffusion, oxide-film forming technique etc., a MOS transistor shown in Figure 2 was formed in the Si layer of this SOS structure. In the figure, numeral 212 designates a source region, numeral 211 a drain region, numerals 205, 204 and 206 source, drain and gate electrodes respectively, and numeral 201 an SiO$_2$ film. As a result, the source-drain leakage current was approximately 6×10$^{-13}$ A/μm. In contrast, the source-drain leakage current of a MOS transistor fabricated by the use of an SOS structure which was formed similarly to the above example except that the laser irradiation according to this invention was not performed, was approximately 3×10$^{-11}$ A/μm and was larger than the value of the above example. In this manner, according to the present invention, the leakage current can be made much lower, and hence, the industrial production of a dynamic MOS · LSI etc. having hitherto been difficult of fabrication with the SOS structure is permitted.

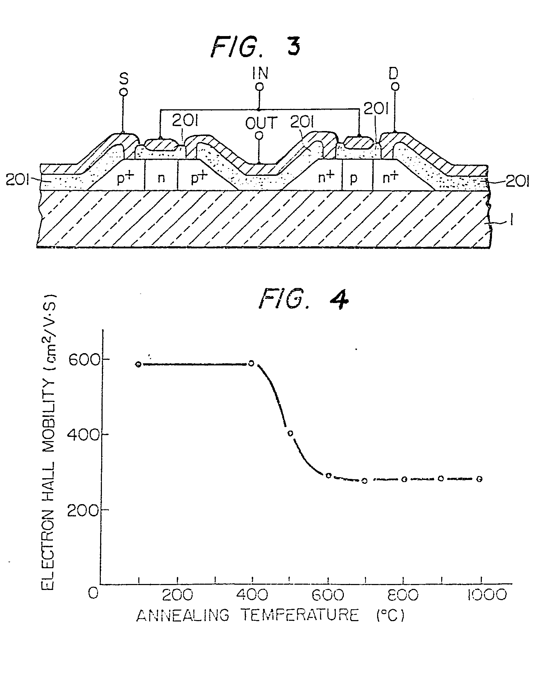

The present invention is applicable to all kinds of semiconductor devices having SOS structures, but it is particularly suitable for a semiconductor device in which both a PMOS type semiconductor element and an NMOS type semiconductor element exist in an identical SOS structure, for example, a semiconductor device which includes CMOS transistors. Figure 3 shows an example of such CMOS transistors. Symbols used are the same as in Figure 2. In Figure 3, a transistor on the left side is of the PMOS type, and a transistor on the right side is of the NMOS type. Figure 3 also illustrates an example of interconnections in the case of employing these transistors as an inverter.

Now, an embodiment of this invention will be described. The present embodiment is characterized, in a semiconductor device of the SOS structure, in that the facial orientation of a Si single crystalline layer is made {100} or {110} and that the portion of the Si single crystalline layer including at least the exposed main surface thereof is put into a re-grown layer on which a tensile stress acts. When the tensile stress is applied to the Si layer whose facial orientation is {100} or {110}, the mobility in the Si layer increases. In accordance with the melting and re-growing process based on the irradiation with the electromagnetic wave, such as laser beam, according to this invention, most of the energy of the irradiating laser is absorbed within the Si single crystalline layer, and a sapphire substrate is held at the normal temperature without being heated. Accordingly, the self-contraction of the molten Si at the re-growth tends to be hampered by the sapphire substrate and the Si single crystalline layer (solid phase) adjacent thereto, and the stress remains in the re-grown layer. The inventors' experiment has revealed, however, that the mobility degrades when the SOS structure with its mobility thus increased is subjected to a high-temperature heat treatment for fabricating a semiconductor device, such as doping with an impurity. The present embodiment prevents the degradation of the mobility by a method to be described below.

4

Description will be made with reference to Figure 4. This figure illustrates the electron Hall mobilities within the Si single crystalline layer at the times when the SOS structure having the Si layer of the (100) crystal the mobility of which has been enhanced owing to the laser irradiation according to this invention has been annealed at various temperatures. The annealing was conducted for the whole SOS structure, and the period of time thereof was about 40 minutes at any of the temperatures. As apparent from Figure 4, when the annealing temperature is below 600°C, the effect of the increase of the mobility appears more or less with respect to the SOS structure not irradiated by the laser, but it cannot be expected at or above 600°C. An annealing temperature of or below 400°C is favorable because the mobility increased by the laser irradiation is not degraded.

It has been found that the above tendency applies, not only when the whole SOS structure is heated, but also when either the substrate or the Si single crystalline layer is heated to the aforecited temperature. For example, as long as the temperature of the substrate is held at or below 400°C, the mobility does not degrade even if the Si single crystalline layer is heated to or above 600°C. The same applies when the temperatures of the substrate and the Si single crystalline layer is in the converse relation to the above. It is accordingly possible to obtain a semiconductor device of the SOS structure having a high operating speed in such a way that the semiconductor device is produced by forming the re-grown layer according to this invention and thereafter holding at least one of the substrate and the Si single crystalline layer at a temperature below 600°C, desirably of or below 400°C. The present invention is applicable to the above-stated Si single crystalline layer having the facial orientation of (100), and besides, to Si single crystalline layers whose main surfaces are faces generally equivalent to the face (100) in the crystallographic sense (the faces are denoted by the {100} face) and the {110} face.

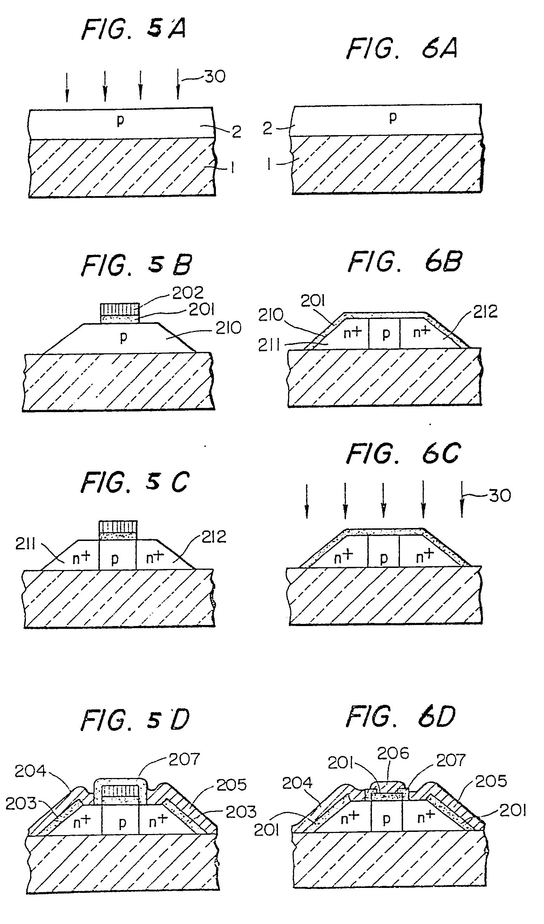

Hereunder, the present embodiment will be described with reference to Figures 5A to 5D and Figures 6A to 6D by taking the fabrications of NMOS transistors as examples.

Reference will be had to Figures 5A to 5D. On one main surface of a sapphire substrate 1, a p-type Si single crystalline layer 2 whose main surface has the facial orientation of (100) was vapor-grown at about 1,000°C. Using the apparatus shown in Figure 1, the single crystalline layer 2 was irradiated with beam 30 to form a re-grown layer. The conditions of the irradiation were the same as stated before. (Figure 5A).

Subsequently, the Si single crystalline layer 2 was selectively etched with a KOH solution at the normal temperature, thereby to form a Si single crystalline island 210. On the exposed part of the Si single crystalline-island 210, a $SiO_2$ film 201 and a Si polycrystalline layer 202 were successively deposited by the plasma CVD process at about 400°C, whereupon their parts other than parts to serve as the gate portion of the MOS transistor were removed by the photolithography. The highest temperature in the application of the photolithography was at the baking of a photoresist film, and the substrate temperature at this time was about 100°C. (Figure 5B).

Next, those parts of the Si single crystalline island 210 which were not covered with the $SiO_2$ film 201 were doped with an impurity establishing the n-type, such as phosphorus, by the ion implantation process so as to form a source region 211 and a drain region 212. The temperature of the substrate 1 at the ion implantation was about 100°C. Thereafter, the source region 211 and the drain region 212 were subjected to the laser annealing in order to activate the implanted ions. Herein, a continuous-wave laser was used. Although the temperature of the surfaces of the source region and drain region was raised to or above approximately 1,000°C by the laser irradiation, the substrate 1 was held at the normal temperature. (Figure 5C).

At the next step, the parts of the Si single crystalline island 210 except parts on which electrodes were to be formed were formed with $SiO_2$ films 203 and 207 by the plasma CVD process at about 400°C. Thereafter, aluminum (Al) was evaporated at the normal temperature to form the source electrode 204 and the drain electrode 205. Then, the MOS transistor was finished up. (Figure 5D).

The channel mobility in the MOS transistor of this example was 700—800 $cm^2/V \cdot s$. This value is much higher than the channel mobility of about 500 $cm^2/V \cdot s$ in a MOS transistor employing the prior-art SOS structure which does not have the re-grown layer according to this invention.

The other example will be described with reference to Figures 6A to 6D. An SOS structure similar to that shown in Figure 5A was prepared (Figure 6A). Subsequently, single crystalline island 210 was formed as in Figure 5B. Thereafter, a source region 211 and a drain region 212 were formed by the use of the techniques of selective thermal diffusion etc. employed in the conventional production of semiconductor devices. The temperature of the thermal diffusion may be a high temperature of, for example, 1,150°C. Shown at 201 is a $SiO_2$ film which was formed on the exposed surface of the single crystalline island 210 by the thermal diffusion step. (Figure 6B).

Subsequently, the Si single crystalline island 210 was irradiated with a laser beam 30 to form a re-grown layer within the Si single crystal. The laser irradiation was conducted with the apparatus shown in Figure 1, and the conditions of the irradiation were as stated in the explanation of the features of this invention. Since the $SiO_2$ film 201 is transparent with respect to the laser beam 30, it does not form an obstacle to the formation of the re-grown layer. (Figure 6C).

Subsequently, those parts of the $SiO_2$ film 201 which corresponded to source and drain electrodes to be formed were etched and removed at the normal temperature, and a $SiO_2$ film 207 was formed by the plasma CVD process at about 400°C. Thereafter, Al was evaporated at the normal temperature to form the source electrode 204, the drain electrode 205 and a gate electrode 206. Then, the MOS transistor was finished up. (Figure 6D).

The channel mobility in the MOS transistor of this example was 700—800 cm$^2$/V · s as in the foregoing example illustrated in Figures 5A to 5D. Although, in the present example, the gate electrode was formed of the evaporated Al film it may well be a polycrystalline Si film as in the foregoing example if desired. Conversely, in the foregoing example, the gate electrode may well be formed of an evaporated metal film of Al or the like. Besides, insofar as at least one of the substrate and the Si single crystal after the formation of the re-grown layer is held at a temperature of below 600°C, processings other than those described above can be performed as desired. Further, in Figure 6D, it is also allowed that without forming the SiO$_2$ film 207, the SiO$_2$ film 201 of the gate region is somewhat enlarged so as to cover the exposed ends of the p-n junctions between the gate region and the source and drain regions. At this time, the plasma CVD treatment for forming the SiO$_2$ film 207 is dispensed with.

While this invention has thus far been described in conjunction with the several embodiments, it is not restricted thereto but can also be realized in different aspects. Examples of the aspects will now be explained.

In the foregoing examples, the pulsating laser beam having the width of 25 nsec was used. However, this invention is not restricted to the aforecited pulse width, but a beam of a width narrower or broader than 25 nsec is also effective. A too broad width, however, is unfavorable because the substrate such as of sapphire is feared to be overheated due to the conduction of heat, to introduce into the semiconductor such harmful impurities as Al atoms within the sapphire substrate.

As the electromagnetic wave source usable in this invention, besides the ruby laser, any laser source may be employed as long as it is a laser capable of oscillating high power and melting substantially the whole region of the semiconductor layer uniformly, such as YAG laser (λ=1064 nm), glass laser (λ=1060 nm), CO$_2$ laser (λ=10600 nm) and Ar laser (λ=514.5 nm). Not only the lasers, but also a flash lamp and a mercury-vapor lamp may be employed.

## Claims

1. A method for fabricating a semiconductor device having a silicon-on-sapphire structure, comprising the steps of:

(a) depositing a silicon layer (2) on a sapphire substrate (1), .

(b) irradiating the layer (2) with an electromagnetic wave to re-crystallize the layer with a {100} or {110} crystallographic orientation at its top main surface, and

(c) applying at least one heat treatment process to the layer (2) after said irradiation,

characterised in that said heat treatment process is conducted under such a condition that the temperature of the layer (2) and/or the substrate (1) is maintained below 600°C to retain tensile stress in the top main surface of the layer (2).

2. The method of Claim 1, characterised in that the wavelength, energy and irradiation time adopted in step (b) are selected so that said silicon layer (2) except a bottom portion, which consists of an interface layer adjoining said substrate (1) and a seed layer adjoining the interface layer, is melted but not heated up to its boiling point.

3. The method of Claim 2, characterised in that a wavelength of 694.3 nm, a pulse width of 25 ns, and an energy density of 1.5 J/cm$^2$ are adopted in step (b).

4. The method of any of Claims 1 to 3, characterised in that step (b) is performed several times.

5. The method of any of Claims 1 to 4, characterised in that the temperature in step (c) is maintained at or below 400°C.

6. The method of any of Claims 1 to 5, characterised in that the heat treatment of step (c) includes doping a part of the re-crystallized layer (2) with impurity atoms and passivating an exposed surface part of the layer (2).

## Patentansprüche

1. Verfahren zur Herstellung eines Halbleiterbauelements mit Silizium-auf-Saphir-Struktur, umfassend die folgenden Schritte:

(a) Aufbringen einer Siliziumshicht (2) auf ein Saphirsubstrat (1),

(b) Bestrahlen der Schicht (2) mit einer elektromagnetischen Welle zum Umkristallisieren der Schicht mit einer {100}- oder {110}-Kristallorientierung an ihrer oberen Hauptoberfläche und

(c) Anwendung mindestens eines Wärmebehandlungsvorgangs auf die Schicht (2) nach der Bestrahlung,

dadurch gekennzeichnet, daß der Wärmbehandlungsvorgang unter der Bedingung durchgeführt wird, daß die Temperatur der Schicht (2) und/oder des Substrats (1) unter 600°C gehalten wird, um in der oberen Hauptoberfläche der Schicht (2) Zugspannung aufrechtzuerhalten.

2. Verfahren nach Anspruch 1, dadurch gekennzeichnet, daß die im Schritt (b) angewandte Wellenlänge, Energie und Bestrahlungszeit so gewählt werden, daß die Siliziumschicht (2) mit Ausnahme eines unteren Teils, der aus einer an das Substrat (1) angrenzenden Zwischenschicht und einer an die

**0 042 175**

Zwischenschicht angrenzenden Keimschicht besteht, geschmolzen aber nicht bis auf ihren Siedepunkt erwärmt wird.

3. Verfahren nach Anspruch 2, dadurch gekennzeichnet, daß im Schritt (b) eine Wellenlänge von 694,3 nm, eine Impulsbreite von 25 ns und eine Energiedichte von 1,5 J/cm$^2$ angewandt werden.

4. Verfahren nach einem der Ansprüche 1 bis 3, dadurch gekennzeichnet, daß der Schritt (b) mehrfach durchgeführt wird.

5. Verfahren nach einem der Ansprüche 1 bis 4, dadurch gekennzeichnet, daß die Temperatur im Schritt (c) bei oder unter 400°C gehalten wird.

6. Verfahren nach einem der Ansprüche 1 bis 5, dadurch gekennzeichnet, daß zu der Wärmebehandlung des Schrittes (c) die Dotierung eines Teils der umkristallisierten Schicht (2) mit Störstoffatomen sowie die Passivierung eines freiligenden Oberflächenteils der Schicht (2) gehören.

**Revendications**

1. Procédé pour fabriquer un dispositif à semiconducteurs comportant une structure silicium-sur-saphir, incluant les étapes consistant à:

(a) déposer une couche de silicium (2) sur un substrat en saphir (1),

(b) irradier la couche (2) avec une onde électromagnétique de manière à recristalliser la couche avec une orientation cristallographique {100} ou {110} au niveau de sa surface principale supérieure, et

(c) soummettre la couche (2) au moins à une opération de traitement thermique après ladite irradiation, caractérisé en ce que ladite opération de traitement thermique est exécutée dans des conditions telles que la température de la couche (2) et/ou du substrat (1) est maintenue inférieure à 600°C de manière à maintenir la contrainte de traction dans la surface principale supérieure de la couche (2).

2. Procédé selon la revendication 1, caractérisé en ce que la longueur d'onde, l'énergie et la durée d'irradiation, adoptées lors de l'étape (b), sont choisies de manière que ladite couche de silicium (2), hormis une partie inférieure constituée par une couche d'interface jouxtant ledit substrat (1) et une couche d'ensemencement jouxtant la couche d'interface, fond, mais n'est pas chauffée jusqu'à son point d'ébullition.

3. Procédé selon la revendication 2, caractérisé en ce qu'on adopte, dans l'étape (b), une longueur d'onde de 694,3 nm, une durée d'impulsion de 25 ns et une densité d'énergie de 1,5 J/cm$^2$.

4. Procédé selon l'une quelconque des revendications 1 à 3, caractérisé en ce que l'étape (b) est exécutée plusieurs fois.

5. Procédé selon l'une quelconque des revendications 1 à 4, caractérisé en ce que la température lors de l'étape (c) est maintenue à une valeur égale ou inférieure à 400°C.

6. Procédé selon l'une quelconque des revendications 1 à 5, caractérisé en ce que le traitement thermique mis en oeuvre lors de l'étape (c) inclut le dopage d'une partie de la couche recristallisée (2) avec des atomes d'impureté et la passivation d'une partie à nu de la surface de la couche (2).

## FIG. 1

2

1

10

42 41

40

30

20

## FIG. 2

211  204  206  201  205  212

201

n+    p    n+

201

1

## FIG. 3

## FIG. 4

0 042 175

FIG. 5 A

FIG. 6A

FIG. 5 B

FIG. 6B

FIG. 5 C

FIG. 6C

FIG. 5 D

FIG. 6D